(19)

Europäisches Patentamt
European Patent Office
Office européen des brevets

(11) **EP 2 958 232 A1**

(12) **EUROPEAN PATENT APPLICATION**

(43) Date of publication:
**23.12.2015 Bulletin 2015/52**

(51) Int Cl.:
**H03F 1/02** (2006.01)    **H03F 1/56** (2006.01)

(21) Application number: **14173009.3**

(22) Date of filing: **18.06.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **NXP B.V.**
**5656 AG Eindhoven (NL)**

(72) Inventor: **Svechtarov, Iordan Konstantinov**
**5656 AG Eindhoven (NL)**

(74) Representative: **Miles, John Richard**
**NXP Semiconductors**
**Intellectual Property and Licensing**
**Red Central**
**60 High Street**
**Redhill, Surrey RH1 1SH (GB)**

(54) **Doherty amplifier**

(57)    The present invention relates to a Doherty amplifier (100). In particular, but not exclusively, the present invention relates to a Doherty amplifier (100) with a wide operating bandwidth. Embodiments disclosed include a Doherty amplifier (100) comprising a main amplifier (102) configured to receive a first signal having a first frequency and amplify the first signal to generate a first amplified signal; a peak amplifier (104) configured to receive a second signal having the first frequency and amplify the second signal to generate a second amplified signal, the peak amplifier (104) only operating when the second signal exceeds a threshold power; a signal combiner (106) configured to combine the first amplified signal and second amplified signal into an output signal on an output line; and a variable load compensator (200) configured to provide a variable load to the signal combiner (106) such that the load impedance of the main amplifier remains substantially constant as the first frequency varies across a bandwidth of the Doherty amplifier (100).

FIG. 2A

EP 2 958 232 A1

**Description**

The present invention relates to a Doherty amplifier. In particular, but not exclusively, the present invention relates to a Doherty amplifier with a wide operating bandwidth.

Modulated radio-frequency (RF) signals are used in a wide variety of communications systems such as mobile phones, cellular base stations for mobile phones and satellite communications. In these applications, it is necessary to amplify the RF signal.

Conventional amplifiers have a generally linear relationship between input drive amplitude and efficiency, and between input power and output power, during normal operation. As input power increases, efficiency and output power both increase. This means that high power is required before high efficiency can be achieved. Eventually, the amplifier is driven into saturation where the relationship between input power and output power is non-linear. In saturation, the output power does not increase as much. It is undesired to operate an amplifier past saturation because driving an amplifier in the non-linear region also increases distortion of the signal. This means conventional amplifiers cannot be used in the high-efficiency region. To overcome this, Doherty topology amplifiers are used.

A Doherty amplifier has a main amplifier and a peak amplifier. The main amplifier is a class AB amplifier. The peak amplifier is a class C amplifier that begins to operate at higher input power levels when the main amplifier starts to saturate. With further increase of the signal amplitude it modulates the load of the main amplifier in a way that prevents it from reaching deep saturation and consequently limiting the signal distortions

In use, an input signal is split and provided to the main amplifier and peak amplifier. The outputs of the two amplifiers are combined to give an amplified output signal. At low input power, only the main amplifier is operational. At high input power, the peak amplifier is also operational. By using this arrangement, high efficiency and linear performance can be achieved.

RF signals in communications systems often have a high ratio of average power to peak power (PAR) (sometimes 8dB or higher). To ensure that the Doherty amplifier is operated in the linear region across the whole power range of the input, so that the amplifier is efficient and has reduced signal distortion, the Doherty amplifier is operated with the input power reduced from the maximum possible. This is known as operating the amplifier in back-off mode.

Conventionally, the circuitry used to combine the amplified signals from the main amplifier and the peak amplifier includes a quarter wavelength transmission line, to phase and impedance match the amplified signals. This causes a bottleneck that limits the frequencies over which the amplifier can be used. Therefore, to cover a wide bandwidth, a number of different amplifiers have to be implemented which is costly in time and resources and inefficient in power consumption.

WO2008/062371A2 discloses using an LC Pi-network to combine the signals instead of a transmission line. The Pi-network is formed by an inductor coupled to the output parasitic capacitances of the transistors of the main and peak amplifiers. However, the value of the inductor, and the semiconductor material system used, limit the range of frequencies over which the amplifier can be used.

According to a first aspect, there is provided a Doherty amplifier as claimed in claim 1.

The variable load compensator offsets changes in the impedance experienced by the main amplifier (i.e. the load impedance of the main amplifier) that occur when the frequency of the signal being amplified changes. This means that the first amplified signal and second amplified signal can be phase and impedance matched over a larger range of the first frequency and the amplifier can operate over a large bandwidth.

Optionally, the variable load may be dependent on the first frequency.

The variable load may have a variable phase and a variable impedance magnitude.

The Doherty amplifier may comprise a combining impedance inverter between the main amplifier and the peak amplifier, the combining impedance inverter being arranged to introduce a ninety degree phase shift between the first amplified signal and the second amplified signal.

The combining impedance inverter may be arranged to transform the variable load such that a substantially constant load is provided at the main amplifier output.

Optionally, the combining impedance inverter may comprise an inductor coupled to the output parasitic capacitances of the main amplifier and the peak amplifier.

The combining impedance inverter provides further improvements of the range of frequencies over which the Doherty amplifier may operate.

The combining impedance inverter may have a nominal operating frequency and the variable load compensator may offset changes in the combined impedance of the main amplifier, the peak amplifier and the combining impedance inverter.

The load compensator may offset changes in the combined impedance of the main amplifier, the peak amplifier and the combining impedance inverter when the first frequency is different to the nominal operating frequency.

Optionally, the Doherty amplifier may comprise input circuitry configured to receive an original signal; divide the original signal to provide the first signal and second signal; and introduce a ninety degree phase shift between the second signal and the first signal.

Optionally, the variable load compensator may comprise an impedance inverter providing a load dependent on the signal of the frequency passing therethrough.

The impedance inverter may comprise a first inductor, a first capacitor and a second capacitor, arranged in a pi-network, wherein the pi-network is arranged to be coupled to the output line at a connection point between the first capacitor and the first inductor.

Alternatively, the impedance inverter may comprise a quarter wavelength transmission line providing a load dependent on the signal of the frequency passing there through.

Depending on the requirements of the system, the pi-network or the transmission line may be advantageous. The pi-network is generally smaller, and thus easier to include in a small package size. However, the transmission line has a more symmetric electrical response, which may be desirable, but if a high K dielectric is used to reduce the physical size the performance may become temperature dependent.

The variable load compensator may further comprise a further inductor connected between the impedance inverter and the output line.

The Doherty amplifier may have a relative bandwidth of more than 30%.

The relative bandwidth of an amplifier is given by the following equation:

$$\frac{2(f_2 - f_1)}{(f_2 + f_1)} \times 100$$

where $f_2$ is the upper bound of the operating bandwidth and $f_1$ is the lower bound of the operating bandwidth. A relative bandwidth of more than 30% means that the amplifier can operate over a large range of frequencies.

The variable load compensator may be connected to the signal combiner at the power combination point

According to a second aspect of the invention, there is provided a base station comprising a Doherty amplifier according to the first aspect, the Doherty amplifier with a peak power between approximately 200W and approximately 800W.

The Doherty amplifier is useful in a base station because a single amplifier can operate over a number of bands to amplify RF signals. This simplifies the base station, reducing power consumption, size and cost.

Optionally, the Doherty amplifier may be arranged to operate with peak efficiency at a back-off of between 8dB and 9dB.

This means the amplifier will operate efficiently for signals with peak to average ratios of up to 7dB or 8dB or more, as required by base stations.

According to a third aspect of the invention, there is provided a mobile communication device comprising a Doherty amplifier according to the first aspect, the Doherty amplifier operating at a power of between approximately 100mW to 1 W.

According to a fourth aspect of the invention, there is provided a method of operating a Doherty amplifier, the method comprising: amplifying a first signal and a second signal at a main amplifier and a peak amplifier of a Doherty amplifier; combining the first signal and the second signal at a signal combiner to provide an output signal; and providing a variable load such that the load impedance of the main amplifier is substantially constant over a range of frequencies of the first signal and the second signal.

A feature of any one of the above aspects of the invention may be applied, mutatis mutandis, to any of the other aspects of the invention.

The invention is described in further detail in the following by way of exemplary embodiments and with reference to the accompanying drawings, in which:

Figure 1 is a schematic drawing the output of a Doherty amplifier incorporating an LC Pi-network;
Figure 2A is a schematic drawing the output of a Doherty amplifier according to embodiments of the invention;
Figure 2B is a schematic drawing of one example of a variable load compensator;
Figure 3 shows the effect of the variable load compensator on the phase and impedance magnitude of the Doherty amplifier load;
Figure 4 shows the frequency response of a Doherty main amplifier load, with and without the variable load compensator, operated in back-off;
Figure 5 shows the frequency and power dependence of the gain and efficiency of a Doherty amplifier incorporating a variable load compensator;
Figure 6A shows a plan view of a package incorporating a Doherty amplifier, including a variable load compensator, formed from separate die;

Figure 6B shows a side view of the package of Figure 6A;

Figure 7 shows a plan view of a package incorporating a Doherty amplifier, including a variable load compensator, where at least some components are provided on the same die;

Figure 8 shows a plan view of a package incorporating a Doherty amplifier and input circuitry;

Figure 9 shows a method of operating a Doherty amplifier; and

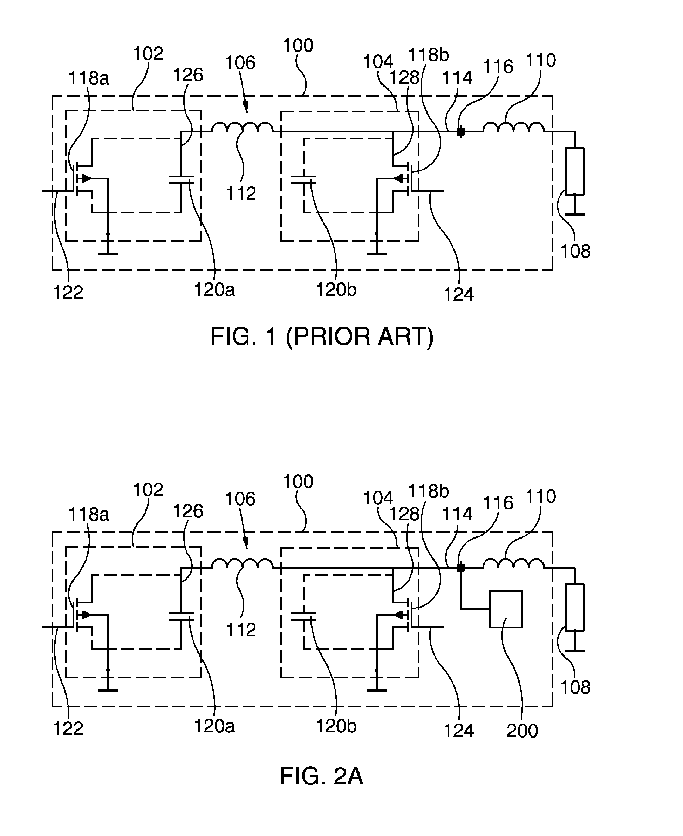

Figure 1 is a schematic diagram of a circuit for the output of a prior art integrated Doherty amplifier 100 incorporating a LC Pi-network.

Before the output of the Doherty amplifier 100, an original RF signal is received and split into at least a first signal and a second signal. The split signals have the same frequency and are out of phase from each other and reduced in power from the input signal.

The Doherty amplifier 100 amplifies the signals at the main amplifier 102 and the peak amplifier 104 and combines the amplified signals into an output signal at signal combiner 106. Since there is a phase difference between the first signal and second signal, there is also a phase difference between the first amplified signal and the second amplified signal. The signal combiner 106 introduces a similar phase difference, so that the first amplified signal and second amplified signal are in phase when they are combined.

After the Doherty amplifier 100, the output signal can be provided to an external load 108.

The main amplifier 102 includes a main amplifier transistor 118a. The first signal is provided to the main amplifier transistor 118a on the first signal input line 122. The first signal is then amplified at the main amplifier transistor 118a to provide the first amplified signal on main amplifier output line 126.

As discussed above, the main amplifier transistor 118a is operated as a class AB amplifier, at a point up to and close to saturation.

The peak amplifier 104 includes a peak amplifier transistor 118b. The second signal is provided to the peak amplifier transistor 118b on the second signal input line 124.

As discussed above, the peak amplifier transistor 118b is operated as a class C amplifier. This means that the peak amplifier 104 is only operational when the power of the second signal is above a threshold. The threshold is controlled by the gate voltage of the peak amplifier transistor 118b.

When operational, the peak amplifier 104 amplifies the second signal to provide the second amplified signal on peak amplifier output line 128.

A parasitic capacitance is formed between the source and drain contacts of the main amplifier transistor 118a. Similarly, a parasitic capacitance is formed between the source and drain contacts of the peak amplifier transistor 118b. Schematically, these are represented in Figure 1 as the capacitor 120a in the main amplifier 102 and the capacitor 120b in the peak amplifier 104.

The first amplified signal and the second amplified signal are provided to signal combiner 106. Signal combiner 106 includes an inductor 112 connected between the main amplifier output line 126 and the peak amplifier output line 128.

The combining inductor 112 of the signal combiner 106 is coupled to the parasitic capacitances 120a, 120b of the main amplifier transistor 118a and the peak amplifier transistor 118b. The combining inductor 112 and parasitic capacitances 120a, 120b form a Pi-network that acts as a combining impedance inverter to match the phases and impedance of the first amplified signal and the second amplified signal.

The first amplified signal and the second amplified signal are combined by the combining impedance inverter to give an output signal on the output line 114. Schematically, the first amplified signal and second amplified signal can be considered to combine at a power combination point 116.

The output line 114 can then be used to provide the output signal to output load 108. Typically, the output line 114 will be connected to the output load 108 via physical connections, such as bond wires. These will introduce a further load to the Doherty amplifier. Schematically, this can be represented as an output inductor 110.

The power combination point 116 may be considered to be anywhere from the point where the output line 128 of the peak amplifier meets the output of the combining inductor 112 up to the output inductor 110.

The performance of the signal combiner 106 is dictated by the properties of the combining inductor 112 and the parasitic capacitances 120a, 120b. The parasitic capacitances 120a, 120b are fixed by the structure of the main amplifier transistor 118a and the peak amplifier transistor 118b. Therefore, to properly phase and impedance match the first amplified signal and second amplified signal, the correct value inductor should be chosen for the combining inductor 112. This is dependent on the frequency of the first signal and the second signal. Therefore, the Doherty amplifier 100 will have a nominal operating frequency, $f_0$, for which the signal combiner 106 is optimised.

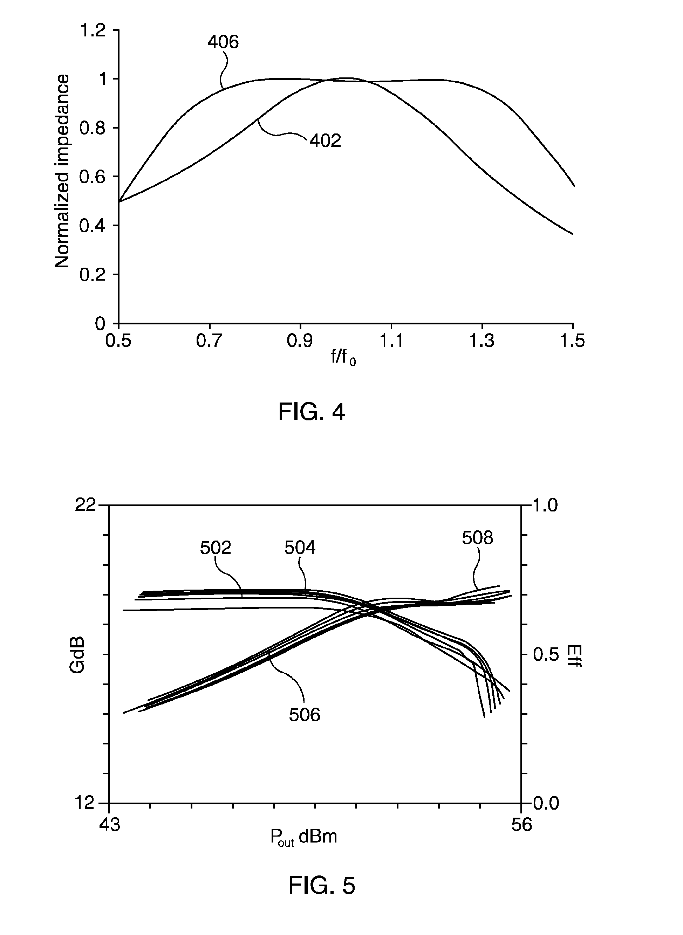

Figure 4 shows the variation in load impedance of the main amplifier 102 of the Doherty amplifier 100 of Figure 1 as the frequency, f, is varied around the nominal operating frequency, $f_0$. The impedance is normalised against a reference value, at the nominal operating frequency $f_0$. The operation of the Doherty amplifier 100 of Figure 1 at 6 dB back-off is the curve 402 with a pronounced peak at approximately $f/f_0 = 1$ As can be seen, at back-off, the impedance falls off sharply away from the nominal operating frequency, f. The fall off is indicative of the first amplified signal not being properly amplified. A certain amount of error is acceptable in the operation of the Doherty amplifier 100 and so the Doherty amplifier 100 can be used at frequencies where the normalised impedance is above a threshold. In other words, the operating bandwidth of the Doherty amplifier 100 is the range at which the normalised impedance is above the threshold. In one example, the threshold may be 0.9, but, any reasonable threshold may be used.

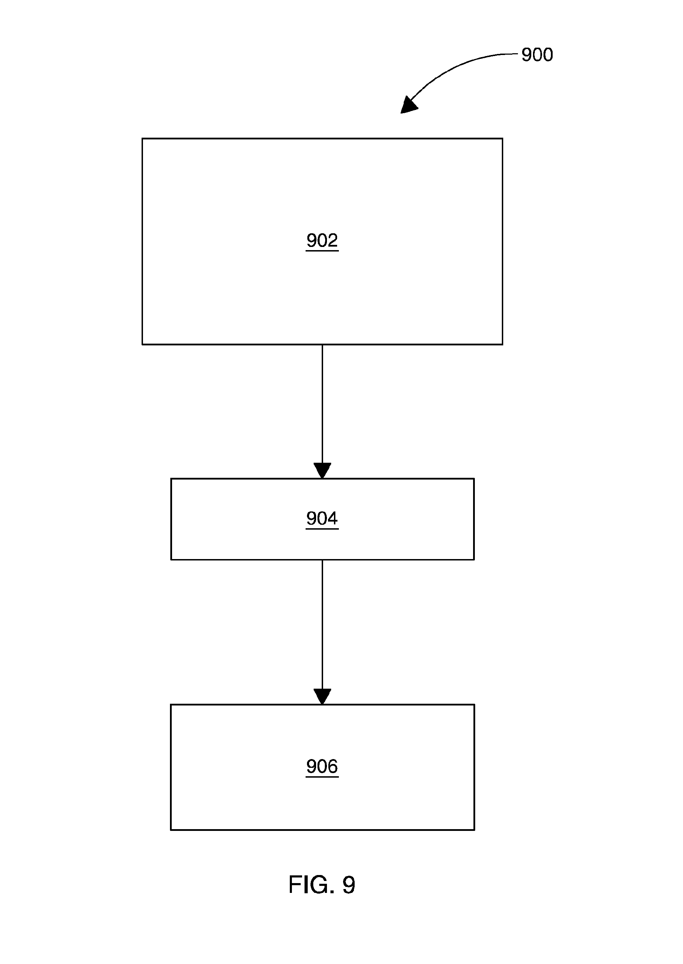

In contrast with the Doherty amplifier of Figure 1, a Doherty amplifier 100 in accordance with some example of this invention can be used over a wide range of frequencies with improved gain and efficiency bandwidth. Figure 2A is a schematic diagram of a circuit for a Doherty amplifier 100 according to some examples of this invention. Where appropriate, the same reference signs have been used as in Figure 1. The operation of the Doherty amplifier of Figure 2A is shown in Figure 9.

Figure 9 is schematic only and is not intended to show sequential steps that occur. Actions shown by the boxes of Figure 9 may occur at least partially simultaneously and any changes in load etc.. may be gradual as the frequency shifts.

The Doherty amplifier 100 of Figure 2A includes a variable load compensator 200. The variable load compensator 200 is connected at the power combining point 116 and, with the output inductor 110 and the output load 108, presents the power combination point 116 with a variable load.

In the Doherty amplifier 100 of Figure 1, when the frequency, f, of the first signal and the second signal is not the same as the nominal operating frequency, $f_0$, the value of the combining inductor 112 is no longer optimal to achieve the correct phase and impedance matching of the first amplified signal and the second amplified signal, and the overall impedance of the Doherty amplifier is changed. The variable load compensator 200 provides a load that offsets the changes to the impedance. The effect of the variable load is that the impedance of the components to the right (when looking at Figure 2A) of the main amplifier transistor 118a (i.e. the main amplifier parasitic capacitance 120a, combining inductor 112, peak amplifier 104, the output inductor 110 and the output load 108) remains constant over a large range relative to a circuit without such a variable load (such as shown in Figure 1). In other words, the ideal internal current source of the main amplifier transistor 118a experiences an approximately constant impedance irrespective of the frequency, across a wide frequency band, limited only by the impedance seen by the main amplifier 102 when operating at back-off. The operating band width of the Doherty amplifier 100 is therefore increased greatly in an efficient manner.

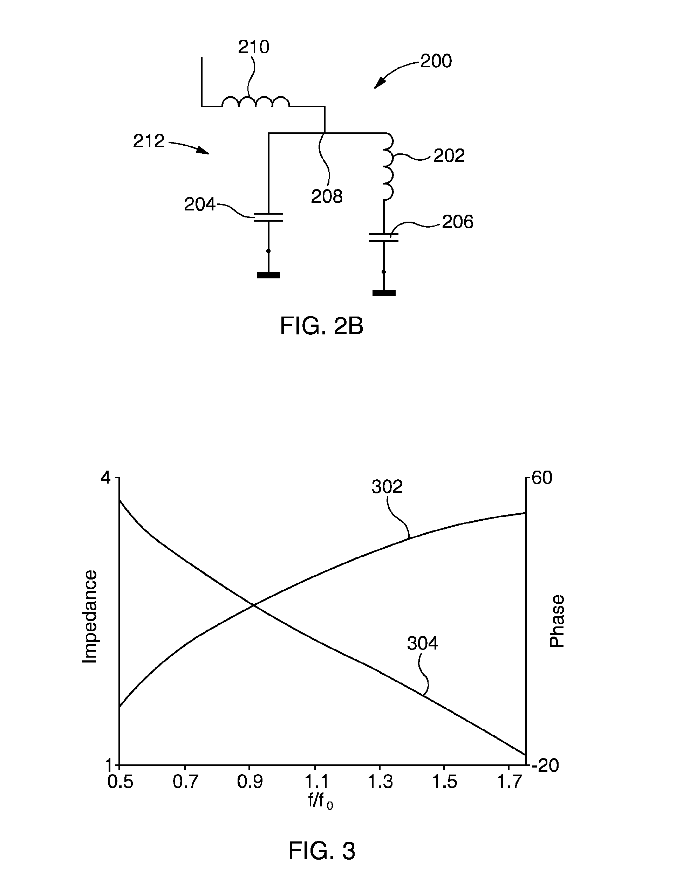

To provide a load that offsets changes in the Doherty amplifier 100 resulting from changes in the frequency, f, the variable load is frequency dependent. In particular, the phase and the impedance magnitude of the variable load compensator 200 vary depending on the frequency, f, of the first signal and the second signal. Figure 3 shows the phase (right hand vertical axis) and the total impedance (left hand vertical axis) of the variable load compensator 200, the output inductor 110 and the output load 108. The phase is shown by the curve 304 decreasing as f increases and the impedance is shown by the curve 302 increasing as f increases.

One example of a variable load compensator 200 is shown in Figure 2B. The variable load compensator 200 comprises an inductor 202 and a pair of capacitors 204, 206 arranged in a Pi-network formation 212. In other words, the inductor 202 is provided between the capacitors 204, 206. Both capacitors are connected to ground.

The Pi-network 212 is coupled to the power combination point 116 via a connection point 208. The connection point is provided between a first capacitor 204 of the Pi-network 212 and the inductor 202. In the example shown in Figure 2B, a further inductor 210 is provided between the Pi-network 212 and the power combination point 116.

In use, when the variable load compensator 200 is coupled to the power combination point 116, the output signal, having the same frequency as the first signal, the second signal, the first amplified signal and the second amplified signal, passes through the variable load compensator 200. The Pi-network 212 can be considered to have an electrical length. The impedance of the Pi-network is dependent on the electrical length and the electrical length is dependent on the frequency of signal passing through the Pi-network. Therefore, as the frequency changes, the phase and impedance of the variable load compensator 200 varies.

The exact response of the variable load compensator 200 is adjusted by suitable choice of the values of the capacitors 204, 206 and the inductors 202, 210. The inductor 210 provided between the Pi-network 212 and the power combination point 116 should be kept to a minimum. In many examples, this inductor 210 is not necessary and can be omitted, and is considered optional.

An alternative example of a variable load compensator 200 that passively responds to changes in frequency, f, is a quarter wavelength transmission line. The length of the quarter wavelength transmission line is determined at $f_0$, connected between the power combination point 116 and ground. The electrical length of the transmission line alters in dependence of the frequency passing through it and thus functions in a similar fashion to the Pi-network 212.

When using a quarter wavelength transmission line, the inductor 210 can be included. The inductor 210 is connected between the transmission line and the power combination point 116. However, as with the Pi-network 212 example, the inductor 210 is not necessary and can be omitted.

Figure 4 also show the variation in impedance of the main amplifier 102 of the Doherty amplifier 100 of Figure 2 as the frequency, f, is varied around the nominal operating frequency, $f_0$. The operation of the Doherty amplifier 100 of Figure 2 at 6 dB back-off is the curve 406 with the plateaux at a normalised impedance of around 1.

Comparison of the curve 402 showing operation of the Doherty amplifier 100 of Figure 1 at back-off to the curve 406 showing operation of the Doherty amplifier 100 of Figure 2 at back-off shows that when operated at back-off, the variable load compensator 200 reduces the fall-off in impedance as the frequency, f, moves away from the nominal operating frequency, $f_0$. Figure 5 shows the variation in gain (left hand vertical axis) and efficiency (right hand vertical axis) as a function of the output power of the Doherty amplifier 100 of Figure 2A. The gain curves 502 starts at a high gain and drop off as the output power increases. The efficiency curves 506 start at low efficiency and increase with increasing output power. For both gain and efficiency, the different curves represent different frequencies of operation, with the upper most curves 504, 508 corresponding to operating an optimal operating frequency in the band, not necessarily $f_0$. The tight grouping of the curves 502, 506 shows that there is little variation in gain or efficiency with frequency. This is desirable for good operation over a large bandwidth

From Figures 4 and 5, it can be seen that the variable load compensator 200 improves the performance of a Doherty amplifier. The improvement leads to a relative bandwidth of at least 30% and allows a saturated power level of at least 500W to be obtained in high power applications. In some instances, the relative bandwidth can be 40% or higher. Similarly, the saturated power level can be 800W or higher.

The results shown in Figures 3 to 5 have been modelled for a Doherty amplifier in which:

- ■ The parasitic capacitance 120a of the main amplifier 118a = 32 pF
- ■ The parasitic capacitance 120b of the peak amplifier 118b = 32 pF
- ■ The inductance of the combining inductor 112 = 0.98 nH
- ■ The output inductor 110 is assumed to have impedance = 0.22 nH
- ■ The output load 108 is provided by impedance matching the Doherty Amplifier 100 network to a 50 ohm load.
- ■ The first capacitor 204 of the variable load compensator 200 has capacitance = 45 pF
- ■ The second capacitor 206 of the variable load compensator 200 has capacitance = 350 pF
- ■ The first inductor 202 of the variable load compensator 200 has inductance = 0.65 nH
- ■ The optional inductor 210 of the variable load compensator has inductance = 0.1 nH
- ■ The semiconductor system used is Si LDMOS
- ■ The transistors are Field effect transistors.

Suitable material systems that can be used include GaAs and GaN. Si, Si-Ge Any suitable type of transistor may be used in the Doherty amplifier 100 of Figure 2A. For example, a LDMOS transistor, MOS transistor or other field effect transistor (FET), HBT or bi-polar junction transistor (BJT) may be used. Furthermore, the above variable load compensator is equally applicable to symmetric and asymmetric Doherty amplifiers.

In symmetric Doherty amplifiers, the gate width of the main amplifier transistor 118a is the same as the gate width of the peak amplifier transistor 118b. In asymmetric Doherty amplifiers, the gate widths are different. The gate widths can be used to control the back-off at which maximum efficiency occurs. For example, increasing the gate width of the peak amplifier transistor 118b relative to the gate width of the main amplifier transistor 118a, increases the back-off at which maximum efficiency occurs.

The values indicated above are by way of example only and are indicative of the qualitative improvement that can be achieved. Any suitable value component may be used, depending on the characteristics of the Doherty amplifier that are required for the particular application.

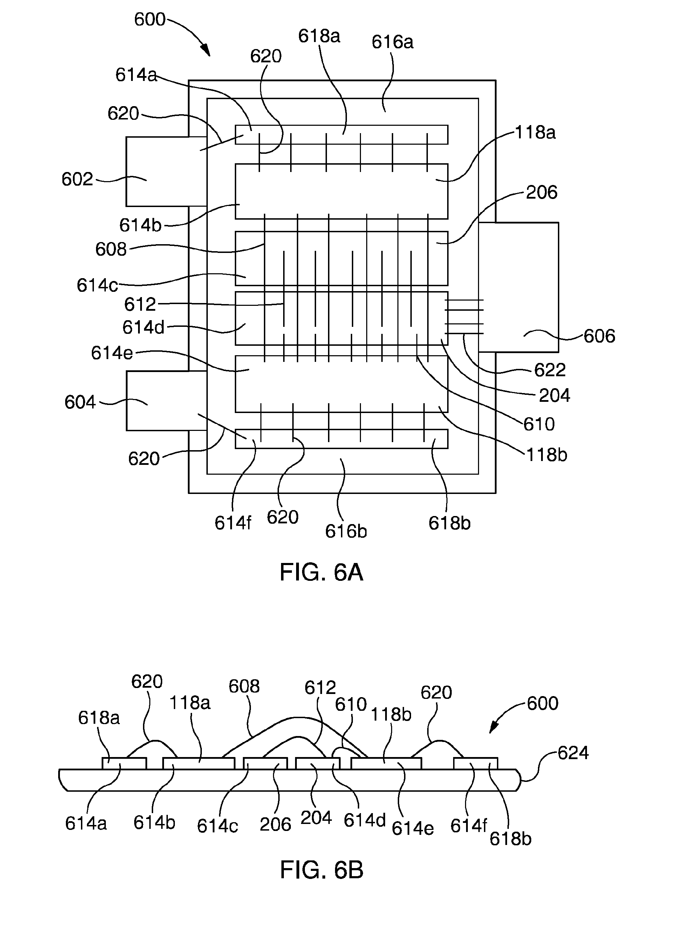

Figures 6 to 8 are schematic illustrations of realisations of the circuit shown in Figure 2A. In Figures 6 to 8, the Doherty amplifier 100 is provided in a package 600 to allow integration of the Doherty amplifier 100 into wider systems. Any suitable package 600 may be used. In some examples, the package 600 is compatible with existing systems so that the Doherty amplifier 100 can be integrated without further changes being required.

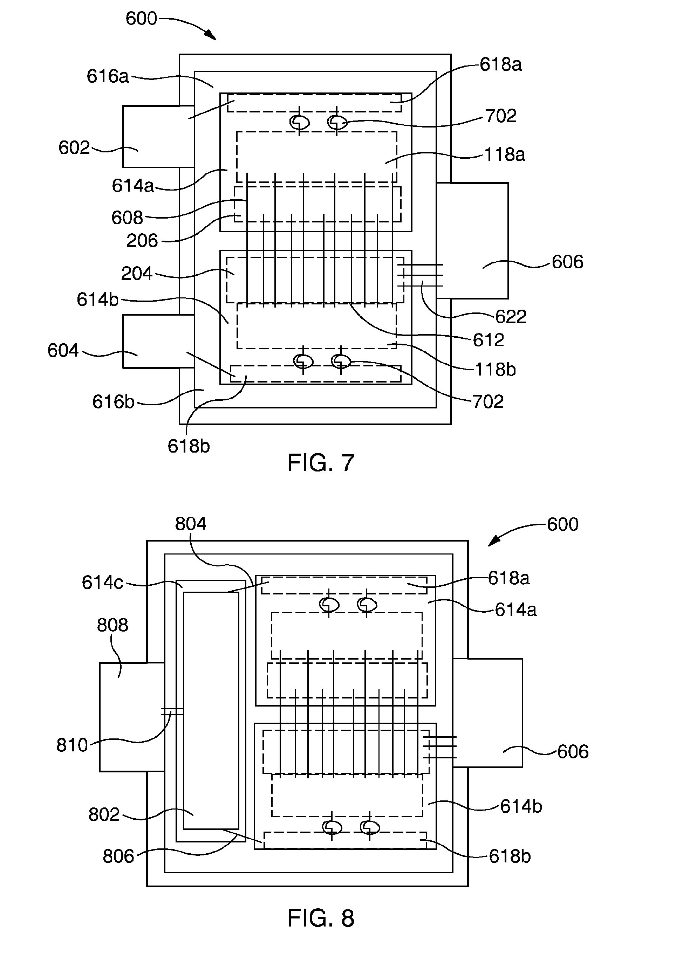

The package 600 includes an output terminal 606 for connection of the output load 108 (not shown in Figures 6 to 8). In some examples, shown in Figures 6 and 7, the package 600 also includes input terminals 602, 604, through which the first and second signals are provided.

The input terminals 602, 604 are connected to a separate component, for example a hybrid coupler (not shown), which receives an original input RF signal and splits the signal into the first signal and the second signal, with a phase difference between the signals. Circuitry for achieving this is known in the art.

The package 600 for the Doherty amplifier 100 also includes filtering circuitry 616a, 616b connected between the input terminals and the main and peak amplifier transistors 118a, 118b. The filtering circuitry provides a low pass filter at each input. The low pass filter is formed by inductors 620 and capacitors 618a, 618b to process the input signals.

The Doherty amplifier 100 comprises a number of components that are provided on a semiconductor chip:

- Main amplifier transistor 118a
- Peak amplifier transistor 118b;
- Capacitors of the variable load compensator 204, 206; and
- Capacitors 618a, 618b of the filtering circuitry 616a, 616b.

The drain and gate contacts of the transistor 118a, 118b are provided on the front face of the chip. The source contact for each transistor is internally connected by diffusion to the rear face of the chip. The capacitors 204, 206, 616a, 616b are provided as vertical devices, with an upper contact on the front face of the chip (i.e. the same face as the semiconductor contacts) and a lower contact on the rear face. The lower contacts are connected to a common ground unless otherwise indicated. The dies are provided on to the metal flange 624 of the package.

The components can each be provided on separate die 614, all on integrated on the same die 614, or with partial integration onto a number of dies 614.

Figures 6A and 6B show each component implemented on a single die 614a-f. Bond wires 620 connect input plate 602 to the upper contact of capacitor 618a and the upper contact of first input capacitor 618a to the gate contact of the main amplifier transistor 118a. The bond wires provide inductors and thus the combination of bond wires 620 and first input capacitor 618a provide filtering circuitry 616a for the first signal.

Similarly, bond wires 620 connect input plate 604, the upper plate of second input capacitor 618b and the gate contact of peak amplifier transistor 118b, forming filtering circuitry 616b for the second signal.

Bond wires 608 connect the drain contacts of the main amplifier transistor 118a and the peak amplifier transistor 118b. Again, the bond wires form an inductor and so the bond wires 608 that connect the drain contacts of the main amplifier transistor 118a and the peak amplifier transistor 118b correspond to the combining inductor 112.

Similarly, bond wires 610 connect the drain contact of the peak amplifier 118b to the upper contact of the first capacitor 204 of the variable load compensator 200, providing the optional inductor 210 of the variable load compensator 200. Different bond wires 612 also connect the upper contacts of the first capacitor 204 and the second capacitor 206 of the variable load compensator 200, providing the inductor 202 of the Pi-network 212 of the variable load compensator 200.

Bond wires 622 also connect the drain contact of the peak amplifier transistor 118b to the output terminal 606, corresponding to the output inductor 110.

Figure 7 illustrates an example where only two dies are used. The first input capacitor 618a, main amplifier transistor 118a and the second capacitor 206 of the variable load compensator 200 are provided on a first die 614a. The separate components are electrically isolated on the die 614a, with contacts 702 between the upper contacts of the first input capacitor 618a and the main amplifier transistor 118a. The contacts 702 provide the inductors necessary for the filtering circuitry 616a, 616b.

Similarly, second input capacitor 618b, peak amplifier transistor 118b and the first capacitor 204 of the variable load compensator 200 are provided on a second die 614b. As shown schematically in Figure 7, the top plate of the first capacitor 204 of the variable load compensator 200 is directly connected to the peak amplifier transistor 118b drain contact. In this way, the optional inductor 210 of the variable load compensator 200 can be omitted. The peak amplifier transistor 118b is isolated from the second input capacitor 618b, with contacts 702 connecting the two.

It will be appreciated that in the example with two die 614a, 614b, the optional inductor 210 can still be included by isolating the first capacitor 204 of the variable load compensator 200 from the peak amplifier transistor 118b, in a similar way to the first die 614a.

In the examples shown in Figure 6 and 7, six dies and two dies 614 have been shown respectively. It will be appreciated that the same techniques can be applied such that any number of die between (and including) one and six may be used.

In applications where high power is required, multiple dies 614 are preferable since the components need to be larger and so the dies will be larger. Larger dies are more susceptible to breaking during the normal heating and cooling experienced in use. However, for low power use, fewer dies save space and are easier to implement.

Figure 8 also shows an example implementation of a Doherty amplifier 100 with two dies 614a, 614b. However, the package of Figure 8 includes a third die 614c. In this example, package 600 includes a single input 808 for receiving the original RF signal and input circuitry 802, that splits the signal into the first signal and the second signal, is provided on the third die 614c. The first signal and second signal are provided to the filtering circuitry 616a, 616b by bond wires 804, 806.

In the example of Figure 8, the separate package for receiving the signal, separate input terminals 602, 604 and bond wires 620 from the input terminals 602, 604 are not necessary.

Although the input circuitry 802 has only been shown in Figure 8 as being a single die and has been shown in combination with the example where the Doherty amplifier 100 is implemented on two dies 614a and 614b, the input circuitry may be provided on multiple die and may be used with a Doherty amplifier 100 provided any number of dies 614. Furthermore, the input circuitry or components of the input circuitry may be incorporated on the same die as the whole Doherty amplifier 100 or components of the Doherty amplifier 100. Indeed, a single die may be used for the input circuitry 802 and the Doherty amplifier 100.

The disclosed Doherty amplifiers 100 may be used in a wide range of applications. By way of example only, two particular applications will now be briefly discussed.

Cellular base stations require high power operation at a back off of between 8dB and 9dB. Suitable choice of the semiconductor material systems, component size and number of dies will lead to a Doherty amplifier with peak efficiency in the desired back-off range and 800W maximum power.

Mobile communication devices have lower power and back-off requirements than base stations. Once again, suitable choice of semiconductor material systems, component size and number of die will lead to a Doherty amplifier with peak efficiency in the desired back-off range and maximum power of between 100mW and 10W.

In the above, the original signal has only been split into a first and second signal and the Doherty amplifier 100 includes a main amplifier 102 and a single peak amplifier 104. However, it will be appreciated that any number of peak amplifiers may be incorporated and the original signal may be split into any number of signals.

In the above, two different examples of variable load compensators 200 have been given (the Pi-network 212 based compensator 200 and a transmission line). However, any suitable impedance inverter may be used, if it provides suitable variable load based on the frequency.

Furthermore, in the above, signal combiner 106 comprising an inductor 112 to achieve the phase matching has been described. However, any suitable signal combiner 106 may be employed, if the appropriate impedance and phase matching is achieved, and if the load of the variable load compensator 200 is transformed such that the drain of the main amplifier transistor 118a sees a fairly constant load independent of the frequency.

In Figures 6 to 8, bond wires 608, 610, 612, 620 have been shown as multiple wires. However, any number of wires may be used, including single wires, to achieve the desired impedance.

REFERENCE SIGNS

| REFERENCE SIGN | FIGURE(S) | DESCRIPTION |
|---|---|---|
| 100 | 1, 2A | INTEGRATED DOHERTY AMPLIFIER |
| 102 | 1, 2A | MAIN AMPLIFIER |
| 104 | 1, 2A | PEAK AMPLIFIER |
| 106 | 1, 2A | SIGNAL COMBINER |
| 108 | 1, 2A | OUTPUT LOAD |
| 110 | 1, 2A | INDUCTOR REPRESENTING BOND WIRES TO OUTPUT |
| 112 | 1, 2A | COMBINING INDUCTOR |
| 114 | 1, 2A | OUTPUT LINE |
| 116 | 1, 2A | POWER COMBINATION POINT |
| 118A | 1, 2A, 6A, 6B, 7 | MAIN AMPLIFIER TRANSISTOR |
| 118B | 1, 2A, 6A, 6B, 7 | PEAK AMPLIFIER TRANSISTOR |
| 120A | 1, 2A | CAPACITOR REPRESENTING MAIN AMPLIFIER OUTPUT PARASITIC CAPACITANCE |
| 120B | 1, 2A | CAPACITOR REPRESENTING PEAK AMPLIFIER OUTPUT PARASITIC CAPACITANCE |
| 122 | 1, 2A | FIRST SIGNAL INPUT |
| 124 | 1, 2A | SECOND SIGNAL INPUT |
| 126 | 1, 2A | FIRST AMPLIFIED SIGNAL OUTPUT |
| 128 | 1, 2A | SECOND AMPLIFIED SIGNAL OUTPUT |
| 200 | 2A, 2B | VARIABLE LOAD COMPENSATOR |
| 202 | 2B | FIRST INDUCTOR |
| 204 | 2B, 6A, 6B, 7 | FIRST CAPACITOR |
| 206 | 2B, 6A, 6B, 7 | SECOND CAPACITOR |
| 208 | 2B | CONNECTION POINT |
| 210 | 2B | SECOND INDUCTOR |
| 212 | 2B | PI-NETWORK |
| 302 | 3 | IMPEDANCE MAGNITUDE AT POWER COMBINATION POINT |
| 304 | 3 | PHASE AT POWER COMBINATION POINT |
| 402 | 4 | NORMALISED IMPEDANCE OF PRIOR ART DOHERTY AMPLIFIER OPERATED AT BACK-OFF |
| 406 | 4 | NORMALISED IMPEDANCE OF DOHERTY AMPLIFIER INCORPORATING A VARIABLE LOAD COMPENSATOR OPERATED AT BACK-OFF |

(continued)

| REFERENCE SIGN | FIGURE(S) | DESCRIPTION |
|---|---|---|
| 502 | 5 | GAIN OF DOHERTY AMPLIFIER INCORPORATING A VARIABLE LOAD COMPENSATOR AT VARYING FREQUENCIES |
| 504 | 5 | GAIN OF DOHERTY AMPLIFIER INCORPORATING A VARIABLE LOAD COMPENSATOR AT OPTIMAL OPERATION |
| 506 | 5 | EFFICIENCY OF DOHERTY AMPLIFIER INCORPORATING A VARIABLE LOAD COMPENSATOR AT VARYING FREQUENCIES |
| 508 | 5 | EFFICIENCY OF DOHERTY AMPLIFIER INCORPORATING A VARIABLE LOAD COMPENSATOR AT OPTIMAL OPERATION |
| 600 | 6A, 6B, 7, 8 | PACKAGE |
| 602 | 6A, 7 | INPUT TERMINAL FOR FIRST SIGNAL |
| 604 | 6A, 7 | INPUT TERMINAL FOR SECOND SIGNAL |
| 606 | 6A, 7, 8 | OUTPUT TERMINAL |
| 608 | 6A, 6B, 7 | CONNECTION FROM MAIN AMPLIFIER TRANSISTOR DRAIN TO PEAK AMPLIFIER TRANSISTOR DRAIN |
| 610 | 6A, 6B | CONNECTION FROM PEAK AMPLIFIER TRANSISTOR DRAIN TO FIRST CAPACITOR |
| 612 | 6A, 6B, 7 | CONNECTION FROM FIRST CAPACITOR TO SECOND CAPACITOR |
| 614A-F | 6A, 6B, 7, 8 | DIE |
| 616A | 6A, 7 | FIRST SIGNAL INPUT NETWORK |
| 616B | 6A, 7 | SECOND SIGNAL INPUT NETWORK |
| 618A | 6A, 6B, 7 | FIRST SIGNAL INPUT CAPACITOR |
| 618B | 6A, 6B, 7 | SECOND SIGNAL INPUT CAPACITOR |
| 620 | 6A, 6B | FIRST AND SECOND SIGNAL INPUT WIRE BONDS |
| 622 | 6A, 7 | BOND WIRE TO OUTPUT TERMINAL |
| 624 | 6B | SUBSTRATE |
| 702 | 7 | ON DIE ELECTRICAL CONNECTIONS |
| 802 | 8 | INPUT CIRCUITRY |
| 804 | 8 | FIRST SIGNAL INPUT CONNECTION |
| 806 | 8 | SECOND SIGNAL INPUT CONNECTION |
| 808 | 8 | MAIN AMPLIFIER INPUT |
| 810 | 8 | MAIN AMPLIFIER INPUT CONNECTION |
| 900 | 9 | METHOD OF OPERATING DOHERTY AMPLIFIER |
| 902 | 9 | METHOD STEP: AMPLIFY FIRST SIGNAL AND SECOND SIGNAL AT A MAIN AMPLIFIER AND PEAK AMPLIFIER OF A DOHERTY AMPLIFIER |
| 904 | 9 | METHOD STEP: PROVIDE VARIABLE LOAD TO SIGNAL COMBINER |
| 906 | 9 | METHOD STEP: COMBINED FIRST AMPLIFIED SIGNAL AND SECOND AMPLIFIED SIGNAL AS OUTPUT SIGNAL AT OUTPUT LINE |

## Claims

1. A Doherty amplifier comprising:

a main amplifier configured to receive a first signal having a first frequency and amplify the first signal to generate a first amplified signal;
a peak amplifier configured to receive a second signal having the first frequency and amplify the second signal to generate a second amplified signal, the peak amplifier only operating when the second signal exceeds a threshold power;
a signal combiner configured to combine the first amplified signal and second amplified signal into an output signal on an output line; and
a variable load compensator configured to provide a variable load to the signal combiner such that the load impedance of the main amplifier remains substantially constant as the first frequency varies across a bandwidth of the Doherty amplifier.

2. A Doherty amplifier as claimed in claim 1, wherein the variable load is dependent on the first frequency.

3. A Doherty amplifier as claimed in claim 1 or claim 2, wherein the variable load has variable phase and variable impedance magnitude.

4. A Doherty amplifier as claimed in any preceding claim, further comprising a combining impedance inverter between the main amplifier and the peak amplifier, the combining impedance inverter being arranged to introduce a ninety degree phase shift between the first amplified signal and the second amplified signal.

5. A Doherty amplifier as claimed in claim 4, wherein the combining impedance inverter is arranged to transform the variable load such that a substantially constant load is provided at the main amplifier output.

6. A Doherty amplifier as claimed in claim 5, wherein the combining impedance inverter comprises an inductor coupled to the output parasitic capacitances of the main amplifier and the peak amplifier.

7. A Doherty amplifier as claimed in any of claims 4 to 6, wherein the combining impedance inverter has a nominal operating frequency and wherein the variable load compensator offsets changes in the combined impedance of the main amplifier, the peak amplifier and the combining impedance inverter.

8. A Doherty amplifier as claimed in claim 7, wherein the variable load compensator offsets changes in the combined impedance of the main amplifier, the peak amplifier and the combining impedance inverter when the first frequency is different to the nominal operating frequency.

9. A Doherty amplifier as claimed in any preceding claim, further comprising input circuitry configured to:

    receive an original signal;
    divide the original signal to provide the first signal and second signal; and
    introduce a ninety degree phase shift between the second signal and the first signal.

10. A Doherty amplifier as claimed in any preceding claim, wherein the variable load compensator comprises an impedance inverter providing a load dependent on the frequency of signal passing therethrough.

11. A Doherty amplifier as claimed in claim 10, wherein the impedance inverter comprises a first inductor, a first capacitor and a second capacitor, arranged in a pi-network, wherein the pi-network is arranged to be coupled to the output line at a connection point between the first capacitor and the first inductor.

12. A Doherty amplifier as claimed in claim 10, wherein the impedance inverter comprises a quarter wavelength transmission line.

13. A Doherty amplifier as claimed in any of claims 10 to 12, wherein the variable load compensator comprises a second inductor connected between the impedance inverter and the output line.

14. A Doherty amplifier as claimed in any preceding claim, wherein the bandwidth is such that the Doherty amplifier has a relative bandwidth of more than 30%.

15. A method of operating a Doherty amplifier, the method comprising:

    amplifying a first signal and a second signal at a main amplifier and a peak amplifier of a Doherty amplifier;
    combining the first signal and the second signal at a signal combiner to provide an output signal; and
    providing a variable load such that the load impedance of the main amplifier is substantially constant over a range of frequencies of the first signal and the second signal.

FIG. 1 (PRIOR ART)

FIG. 2A

FIG. 2B

FIG. 3

FIG. 4

FIG. 5

600

614a

620

620

618a

616a

602

614b

608

614c

612

614d

614e

604

620

614f  620

616b

618b

118a

206

606

622

204

610

118b

## FIG. 6A

620

618a  118a

608

612

610  118b

620

600

624

614a  614b  614c  206  204  614d  614e  614f  618b

## FIG. 6B

**FIG. 7**

**FIG. 8**

900

902

904

906

FIG. 9

## EUROPEAN SEARCH REPORT

Application Number

EP 14 17 3009

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2014/068351 A2 (FREESCALE SEMICONDUCTOR INC [US]; BLEDNOV IGOR [FR]) 8 May 2014 (2014-05-08) * page 9, line 25 - page 10, line 12; figure 5 * | 1-6, 9-11,14, 15 | INV. H03F1/02 H03F1/56 |
| X | US 2012/105147 A1 (HARRIS CHRISTOPHER [SE] ET AL) 3 May 2012 (2012-05-03) * paragraphs [0007], [0070]; figure 10 * | 1-4,6,9, 15 | |
| X | US 2011/279178 A1 (OUTALEB NOUREDDINE [CA] ET AL) 17 November 2011 (2011-11-17) * paragraph [0039] - paragraph [0055]; figures 2-4 * | 1-10,12, 14,15 | |
| X | US 8 593 219 B1 (ROOT LOREN F [US]) 26 November 2013 (2013-11-26) * column 9, line 43 - column 11, line 35; figures 2,3,5 * | 1-5,7-9 | |
| X | MEHDI SARKESHI ET AL: "A novel Doherty amplifier for enhanced load modulation and higher bandwidth", MICROWAVE SYMPOSIUM DIGEST, 2008 IEEE MTT-S INTERNATIONAL, IEEE, PISCATAWAY, NJ, USA, 15 June 2008 (2008-06-15), pages 763-766, XP031441214, ISBN: 978-1-4244-1780-3 * page 1; figures 3,4 * | 1-4,7,8, 10,11, 14,15 | TECHNICAL FIELDS SEARCHED (IPC) H03F |
| X | US 2012/126891 A1 (KIM BUM MAN [KR] ET AL) 24 May 2012 (2012-05-24) * the whole document * | 1-5 | |
| A | WO 2007/142414 A1 (WIPAM INC [KR]; YU DAEKYU [KR]) 13 December 2007 (2007-12-13) * the whole document * | 1-15 | |

The present search report has been drawn up for all claims

| Place of search | Date of completion of the search | Examiner |
|---|---|---|
| Munich | 24 November 2014 | Kurzbauer, Werner |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT**
**ON EUROPEAN PATENT APPLICATION NO.**                    EP 14 17 3009

This annex lists the patent family members relating to the patent documents cited in the above-mentioned European search report.
The members are as contained in the European Patent Office EDP file on
The European Patent Office is in no way liable for these particulars which are merely given for the purpose of information.

24-11-2014

| Patent document cited in search report | | Publication date | Patent family member(s) | | Publication date |
|---|---|---|---|---|---|
| WO 2014068351 | A2 | 08-05-2014 | NONE | | |
| US 2012105147 | A1 | 03-05-2012 | CN | 103181086 A | 26-06-2013 |
| | | | EP | 2636151 A1 | 11-09-2013 |
| | | | JP | 2013545400 A | 19-12-2013 |
| | | | KR | 20130129367 A | 28-11-2013 |
| | | | US | 2012105147 A1 | 03-05-2012 |
| | | | US | 2014065991 A1 | 06-03-2014 |
| | | | WO | 2012061244 A1 | 10-05-2012 |
| US 2011279178 | A1 | 17-11-2011 | CN | 102893517 A | 23-01-2013 |
| | | | EP | 2572449 A2 | 27-03-2013 |
| | | | JP | 2013527711 A | 27-06-2013 |
| | | | KR | 20130038293 A | 17-04-2013 |
| | | | US | 2011279178 A1 | 17-11-2011 |
| | | | WO | 2011145002 A2 | 24-11-2011 |
| US 8593219 | B1 | 26-11-2013 | NONE | | |
| US 2012126891 | A1 | 24-05-2012 | KR | 101128486 B1 | 27-03-2012 |
| | | | US | 2012126891 A1 | 24-05-2012 |
| WO 2007142414 | A1 | 13-12-2007 | CN | 101467346 A | 24-06-2009 |
| | | | TW | 200828784 A | 01-07-2008 |
| | | | US | 2009273398 A1 | 05-11-2009 |
| | | | WO | 2007142414 A1 | 13-12-2007 |

EPO FORM P0459

**EP 2 958 232 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2008062371 A2